# EUROPÄISCHE PATENTSCHRIFT

(11) **EP 3 592 500 B1**
(45) Veröffentlichungstag und Bekanntmachung des Hinweises auf die Patenterteilung: **11.10.2023**
(21) Anmeldenummer: 18708686.3
(22) Anmeldetag: 05.03.2018
(51) Int. Cl.: C03C 15/00, C03C 23/00, B23K 26/00, B23K 26/06, B23K 26/0622, B23K 103/00, B81C 1/00, B23K 26/402, B23K 26/53

(54) **VERFAHREN ZUM EINBRINGEN ZUMINDEST EINER AUSNEHMUNG IN EIN MATERIAL MITTELS ELEKTROMAGNETISCHER STRAHLUNG UND ANSCHLIESSENDEM ÄTZPROZESS**
PROCESS FOR MANUFACTURING A RECESS IN A MATERIAL BY MEANS OF ELECTROMAGNETIC RADIATION AND SUBSEQUENT ETCHING PROCESS
PROCÉDÉ DE FABRICATION D'UN RECOUVREMENT DANS UN MATÉRIAU AU MOYEN D'UN RAYONNEMENT ÉLECTROMAGNÉTIQUE ET AVEC UNE ATTAQUE DE GRAVURE ULTÉRIEURE

(30) Priorität: 06.03.2017 DE 102017104655; 06.03.2017 DE 102017104657
(43) Veröffentlichungstag der Anmeldung: 15.01.2020
(73) Patentinhaber: LPKF Laser & Electronics SE, 30827 Garbsen (DE)
(72) Erfinder: OSTHOLT, Roman, 30855 Langenhagen (DE); AMBROSIUS, Norbert, 30827 Garbsen (DE); SCHNOOR, Arne, 30625 Hannover (DE); DUNKER, Daniel, 30419 Hannover (DE)
(74) Vertreter: Scheffler, Jörg
(86) Internationale Anmeldenummer: PCT/EP2018/055299
(87) Internationale Veröffentlichungsnummer: WO 2018/162385

(56) Entgegenhaltungen:
- WO-A2-2014/161534
- DE-A1-102014 116 958
- JP-A- 2005 190 857
- US-A1- 2003 235 385
- US-A1- 2012 125 893

## Beschreibung

Die Erfindung betrifft ein Verfahren zum Einbringen zumindest einer Ausnehmung, insbesondere Durchbrechung, in ein transparentes oder transmissives, insbesondere plattenförmiges Material, wobei das Material mittels elektromagnetischer Strahlung, insbesondere eines Lasers, entlang einer Strahlachse selektiv modifiziert und die Ausnehmungen anschließend durch einen Ätzprozess erzeugt wird, wobei in einem modifizierten und in den nicht modifizierten Bereichen unterschiedliche Ätzraten auftreten.

Ein gattungsgemäßes Verfahren ist bereits aus der DE 10 2014 116 958 A1 bekannt, die ein optisches System zur Strahlformung eines Laserstrahls sowie ein Verfahren zur Lasermaterialbearbeitung durch Verwendung einer langgezogenen Fokuszone zur Ausbildung einer Modifikation in einem transparenten Material beschreibt. Eine langgezogene Fokuszone bezieht sich dabei auf eine durch das optische System bestimmte dreidimensionale Intensitätsverteilung, die in dem zu bearbeitenden Material das räumliche Ausmaß der Wechselwirkung und damit der Modifikation bestimmt. Derartige Modifikationen ermöglichen ein Trennen, Bohren oder Strukturieren des Materials. Hierzu werden Modifikationen generiert, die ein selektives Ätzen der modifizierten Bereiche ermöglichen.

Die US 2003 / 0 235 385 A1 bezieht sich auf ein Verfahren zur Herstellung einer Mikrostruktur in einem transparenten dielektrischen Material, bei dem durch Fokussieren von Laserpulsen eine stark verjüngte Zone mit modifizierten Ätzeigenschaften, beispielsweise eine doppelt konische Struktur, erzeugt wird, in der die Ätzrate höher ist als in den nicht modifizierten Zonen.

Die JP 2005 - 190 857 A beschreibt ein Verfahren zur Herstellung einer Maske aus einem Glassubstrat durch Bestrahlen des Glassubstrats mit einem Laserstrahl und einen Ätzbehandlungsschritt. Beim Ätzvorgang wird das Glassubstrat in eine Ätzlösung getaucht, sodass die Ätzlösung in den durch den Laserlicht-Bestrahlungsschritt gebildeten modifizierten Bereich eindringt und dieser sich auflöst, wobei das Glassubstratmaterial in der Umgebung des modifizierten Bereichs isotrop geätzt wird, sodass ein kegelförmiger Abschnitt entsteht. Auf diese Weise kann ein Durchgangsloch mit unterschiedlichen Durchmessern auf beiden Seiten des Glassubstrats erzeugt werden, indem zunächst ein Ätzprozess von der ersten Oberfläche durchgeführt wird, um Ausnehmungen mit kegelförmigen Abschnitten zu bilden und der Ätzprozess von der ersten und zweiten Oberfläche fortgesetzt wird, um die Ausnehmungen miteinander zu verbinden und die Durchgangslöcher zu erzeugen.

Die WO 2016 / 041 544 A1 offenbart bereits ein solches Verfahren zum Einbringen mindestens einer Ausnehmung, insbesondere als eine Durchbrechung, in ein plattenförmiges Werkstück. Hierzu wird eine Laserstrahlung auf die Oberfläche des Werkstückes gerichtet. Die Einwirkungsdauer der Laserstrahlung wird äußerst kurz gewählt, sodass lediglich eine Modifikation des Werkstückes konzentrisch um eine Strahlachse des Laserstrahles eintritt. In einem nachfolgenden Verfahrensschritt kommt es aufgrund der Einwirkung eines ätzenden Mediums durch sukzessives Aufätzen zu einem anisotropen Materialabtrag in denjenigen Bereichen des Werkstückes, die zuvor eine Modifikation durch die Laserstrahlung erfahren haben. Entlang der zylindrischen Einwirkungszone entsteht dadurch eine Ausnehmung als Durchbrechung in dem Werkstück. Insbesondere können die in einem ersten Schritt erzeugten Fehlstellen sukzessive vergrößert und damit eine Ausnehmung oder Durchbrechung erzeugt werden. Ein wesentlicher Vorteil dieses Verfahrens besteht darin, dass die Modifikationszone im Wesentlichen zylindrisch koaxial zu der Strahlachse verläuft und so zu einem konstanten Durchmesser der Durchbrechung oder der Ausnehmung führt.

Aus der DE 10 2010 025 966 B4 ist ein Verfahren bekannt, bei dem in einem ersten Schritt auf das Glaswerkstück fokussierte Laserimpulse gerichtet werden, deren Strahlungsintensität so stark ist, dass es zu lokaler, athermischer Zerstörung entlang eines Kanals im Glas kommt.

Ferner ist ein Verfahren zur Bearbeitung von Glas durch die Erzeugung von Filamenten aus der US 2013/126573 A1 bekannt.

Um Strukturen in Glas zu erzeugen, sind darüber hinaus seit langem Ätzverfahren bekannt, beispielsweise die Lithographie. Dabei wird eine Beschichtung belichtet und anschließend lokal geöffnet. Anschließend wird das Substrat geätzt, um die gewünschten Strukturen zu erzeugen. Die Beschichtung dient dabei als Ätzresist. Da der Ätzangriff an den Stellen, an denen der Resist geöffnet wurde, isotrop stattfindet, lassen sich damit aber keine Strukturen mit einem großen Aspektverhältnis erzeugen.

Der Erfindung liegt die Aufgabe zugrunde, einverbessertes Verfahren zum Einbringen zumindest einer Ausnehmung zu schaffen.

Diese Aufgabe wird erfindungsgemäß mit einem Verfahren gemäß den Merkmalen des Anspruches 1 gelöst. Die weitere Ausgestaltung der Erfindung ist den Unteransprüchen zu entnehmen.

Erfindungsgemäß ist also ein Verfahren vorgesehen, bei dem entlang der Strahlachse in dem Material durch die elektromagnetische Strahlung Modifikationen mit unterschiedlichen Charakteristika innerhalb der modifizierten Bereiche erzeugt werden, sodass der Ätzprozess in dem Material inhomogen verläuft und die Ätzraten in den mit unterschiedlichen Charakteristika modifizierten Bereichen bei unveränderten Ätzbedingungen voneinander abweichen, sodass Ausnehmungen mit unterschiedlichen Öffnungswinkeln und/oder Durchmessern auf beiden Seiten des Glassubstrats erzeugt werden, wobei die unterschiedlichen Charakteristika der Modifikationen durch Veränderung der Strahlform der elektromagnetischen Strahlung, insbesondere mittels Phasenmodulation, und/oder durch Variation der Pulsenergie, der Strahlform und/oder der Intensität erzielt werden. Hierdurch wird erfindungsgemäß die Möglichkeit geschaffen, die aufgrund der Ätzbehandlung entstehenden Ausnehmungen, insbesondere Durchbrechungen, in dem transparenten oder transmissiven Material gezielt und selektiv durch unterschiedliche Charakteristika der Modifikationen einzustellen. Somit entsteht beispielsweise eine Aufweitung der Ausnehmung nicht infolge eines längeren Ätzangriffes, sondern aufgrund des schneller voranschreitenden Ätzabtrages in Abhängigkeit der unterschiedlichen Charakteristika der Modifikationen. Dabei lassen sich erfindungsgemäß nicht nur kegelförmige Aufweitungen in oberflächennahen Randbereichen erzeugen. Vielmehr kann umgekehrt solchen Aufweitungen entgegengewirkt werden, um beispielsweise zylindrische oder auch konvexe Ausnehmungen zu erzeugen, in dem die Charakteristika der Modifikationen in dem Bereich zwischen den Oberflächen des Materials so eingestellt werden, dass dort ein bevorzugter Ätzabtrag eintritt.

Indem die unterschiedlichen Charakteristika der Modifikationen durch Veränderung der Strahlform der elektromagnetischen Strahlung insbesondere mittels Phasenmodulation erzielt werden kann die Veränderung der Charakteristika in einem unterbrechungsfreien Arbeitsschritt während der Bearbeitung des Materials erfolgen, sodass die Bearbeitung weitgehend ohne unerwünschte Verzögerungen durchgeführt werden kann.

Darüber hinaus hat es sich ebenfalls als besonders Erfolg versprechend erwiesen, wenn die unterschiedlichen Charakteristika der Modifikationen durch Variation der Fokuslage erzielt werden, sodass die Variation mit einem vergleichsweise geringen Aufwand bei der Prozessführung realisiert werden kann.

Eine weitere, ebenfalls besonders zweckmäßige Ausgestaltung der Erfindung wird auch dann erreicht, wenn mehrfach der Zyklus aus Modifikation und Ätzbehandlung des Materials durchgeführt wird. Indem also nach einer ersten Ätzbehandlung eine erneute Modifikation des Materials erfolgt, kann beispielsweise eine Nachbearbeitung mit höherer Genauigkeit durchgeführt werden. Insbesondere in Verbindung mit einem Ätzprozess mit geringen Ätzraten kann so der Abtrag gezielt gesteuert und bei Erreichen gewünschter Sollwerte beendet werden.

Hierbei hat es sich als besonders zweckmäßig erwiesen, wenn mehrere Ätzschritte, insbesondere mit unterschiedlichen Ätzbedingungen, durchgeführt werden, sodass ein Optimum an Abtragsleistung einerseits und der erzielbaren Genauigkeit andererseits erreicht wird.

Weiterhin hat es sich bereits als vorteilhaft erwiesen, wenn eine Oberfläche des insbesondere plattenförmigen Materials mit einem Ätzresist zumindest abschnittsweise abgedeckt wird und dadurch bei dem nachfolgenden Ätzverfahren vor dem Ätzangriff geschützt ist. Hierdurch kann die Ätzrate durch den einseitigen Ätzangriff gezielt auf die freie Oberfläche konzentriert werden, an welcher ein verstärkter Abtrag erwünscht ist.

Besonders bevorzugt kann durch die Wahl der Prozessparameter der Öffnungswinkel, insbesondere kleiner als 5°, oder der Durchmesser der Ausnehmung beliebig eingestellt werden, wobei die Differenz der Öffnungswinkel aufgrund der Modifikationen mit unterschiedlichen Charakteristika mehr als 10° betragen kann.

Außerdem können Ausnehmungen derart erzeugt werden, dass der Durchmesser und/oder die Form der Ausnehmungen sich um maximal 3 µm unterscheiden.

Als plattenförmiges, für die elektromagnetische Strahlung transparentes oder transmissives Material können unterschiedliche Werkstoffe zur Anwendung kommen, wobei das insbesondere plattenförmige Material vorzugsweise als einen wesentlichen Materialanteil Glas, Silizium und/oder Saphir aufweist und dadurch eine hervorragende physikalische und chemische Beständigkeit aufweist, die sich für vielfältige technische Einsatzzwecke optimal eignet.

Die Erfindung ist nicht auf bestimmte Anwendungsgebiete beschränkt. Besonders bevorzugt ist eine Verwendung des nach dem Verfahren hergestellten plattenförmigen Materials als eine Düsenplatte einer Druckvorrichtung vorgesehen.

Die Erfindung lässt verschiedene Ausführungsformen zu. Zur weiteren Verdeutlichung ihres Grundprinzips ist eine davon in der Zeichnung dargestellt und wird nachfolgend beschrieben. Diese zeigt jeweils in einer Prinzipdarstellung in
- Fig. 1: eine geschnittene Seitenansicht eines mit Durchbrechungen versehenen Glassubstrates;
- Fig. 2: unterschiedlichen Modifikationstypen;
- Fig. 3: verschiedenen Verfahrensschritten bei der Verwendung eines Ätzresistes.

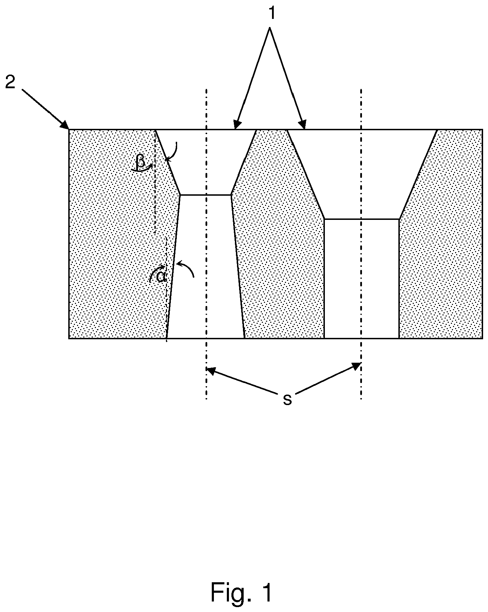

Figur 1 zeigt eine geschnittene Seitenansicht eines mit einer Durchbrechung 1 versehenen Glassubstrates 2 als Material, hergestellt nach dem erfindungsgemäßen Verfahren. Ein wesentlicher Vorteil der vorliegenden Erfindung bei dem Herstellungsverfahren betrifft die individuelle und einstellbare Variation des Kegelwinkels α, β der Durchbrechung 1 in dem Glassubstrat 2.

Wie zu erkennen, wird mit dem erfindungsgemäßen Verfahren erstmals ein Glassubstrat 2 mit Durchbrechungen 1 versehen, die bezogen auf die jeweiligen Außenflächen des Materials einerseits einen geringen Kegelwinkel α von weniger als 2°, andererseits auf der gegenüberliegenden Seite einen großen Kegelwinkel β von etwa 20° aufweisen.

Hierzu wird in einem ersten Schritt beispielsweise ein 100 µm dickes Glas als Glassubstrat 2 mit der Strahlung eines Lasersystems modifiziert. Abhängig von der Leistung, die in das Glas eingebracht wird, lassen sich unterschiedlich starke Modifikationen des Glassubstrates 2 einstellen.

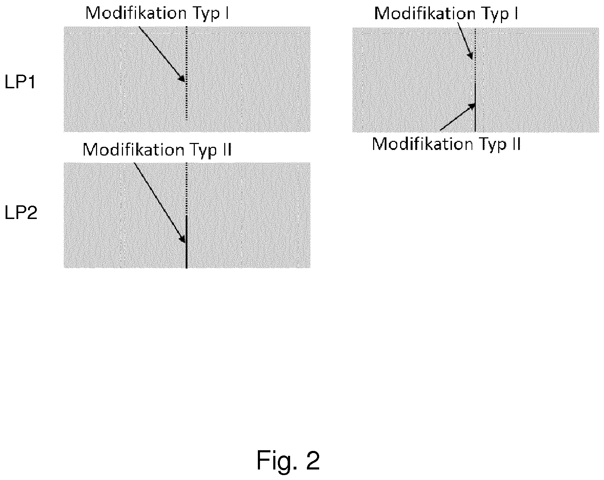

Im Folgenden werden die in Figur 2 dargestellten unterschiedlichen Modifikationen als "Typ I" oder "Typ II" bezeichnet. Dabei soll eine "Typ I"-Modifikation eine geringere Veränderung des Glases darstellen, die ebenfalls durch eine geringere Laserleistung erzeugt wird. "Typ II"-Modifikationen sind entsprechend starke Veränderungen der Glasstruktur und werden durch höhere Laserleistung hervorgerufen.

Durch die sehr hohe Positioniergenauigkeit der Anlage lässt sich sowohl die durch optische Hilfsmittel langgezogene Brennweite des Lasers als auch die Brennweitenposition in dem Glassubstrat 2 sehr genau definieren.

Grundsätzlich lassen sich die "Typ I"- und "Typ II"- Modifikationen in der in Figur 2 auf der linken Seite dargestellten Variante mit zwei oder mehr Laserpulsen LP1, LP2 oder entsprechend der auf der rechten Seite dargestellten Variante mit einem einzigen Laserpuls erreichen.

Ein Übergang von einer "Typ I"-Modifikation (geringe Leistung) zu einer "Typ II"-Modifikation (hohe Leistung) lässt sich so bereits durch einen einzelnen Puls unter Berücksichtigung des Leistungsprofils entlang der Ausbreitungsrichtung des Lasers realisieren.

Zur Verstärkung dieses Effektes und zur Erhöhung des Unterschiedes zwischen beiden Modifikationstypen kann nach einer ersten gleichmäßigen "Typ I"-Modifikation entlang des ganzen Glases ein zweiter Puls erhöhter Leistung und mit einer veränderten Brennweitenposition verwendet werden.

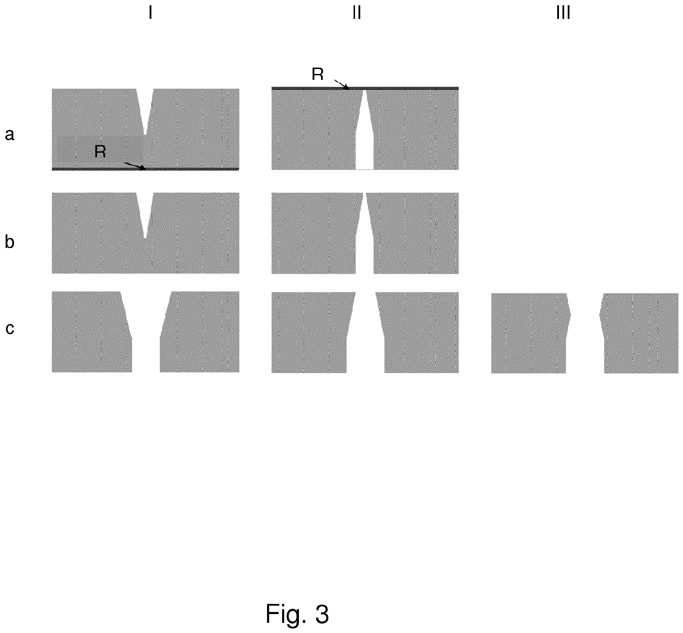

In einem zweiten, in Figur 3 gezeigten Prozessschritt wird eine Seite des Glassubstrates mit einer flusssäurebeständigen Abdeckung, beispielsweise einer Klebefolie als Ätzresist R abgedeckt, sodass in dem folgenden Ätzschritt a nur ein Typ von Modifikation geätzt wird. Nach dem Entfernen des Ätzresistes R in dem Prozesschritt b erfolgt erneut ein Ätzschritt b, wodurch das beidseitige Ätzen des Glassubstrates erreicht wird. Die Varianten I und II unterscheiden sich durch die Anordnung des Ätzresistes R, während bei der Variante III auf ein Ätzresist verzichtet wird.

Da beide Modifikationstypen mit unterschiedlichen Geschwindigkeiten in Flusssäure geätzt werden, resultieren daraus die in Figur 1 dargestellten, voneinander abweichenden Kegelwinkel α, β. Indem zunächst eine Seite vorgeätzt wird, kann ein einseitiger Unterschied des Lochdurchmessers eingestellt werden.

In einem zweiten Ätzschritt können die Durchbrechungen 1 vergrößert werden. Entsprechend des dargestellten Schemas lassen sich so beliebig verschiedene Geometrien realisieren.

Als Ätzmedien wurden folgende nasschemische Lösungen realisiert:
Flusssäure:
   - Konzentration: 1 - 20 %
   - Temperatur: 5 - 40 °C
   - Zweite Säure: H2SO4, HCL, H3PO4
Kalilauge:
   - Konzentration: 10 - 60 %
   - Temperatur: 85 - 160 °C

Anders als beim Stand der Technik können so unterschiedliche Kegelwinkel α, β und Lochdurchmesser auf beiden Seiten des Glassubstrates 2 eingestellt werden. So lassen sich individuelle Geometrien der Durchbrechungen 1 produzieren, wobei insbesondere die nach dem Stand der Technik unvermeidlichen Mikrorisse durch das Laserbohren ausgeschlossen sind. Insbesondere kann der Kegelwinkel α, β der Durchbrechungen 1 im Querschnitt des Substratmaterials veränderlich sein. Beispielsweise ergeben sich daraus Vorteile für die Produktion von Bestandteilen für die Mikrofluidik.

Erfindungsgemäß können entlang der Strahlachse s im Glas mehrere Modifikationen mit unterschiedlichen Charakteristika erzeugt werden, beispielsweise durchgehende Modifikation und Ketten von Bläschen. Dadurch wird der Ätzangriff über die Modifikationslänge inhomogen, insbesondere also die Ätzrate unter konstanten Ätzbedingungen unterschiedlich.

Dabei können folgende Aspekte erfindungsgemäß in vorteilhafter Weise realisiert werden:
- Änderung der Ätzbedingungen in verschiedenen Bereichen
- beidseitiges oder einseitiges Ätzen (Ätzresist)
- Verwendung als Düsenplatte
   ▪ alle Löcher identisch, Genauigkeit < 3 µm
- Öffnungswinkel < 5°
- Unterschied der Öffnungswinkel > 10°
- Unterschiedliche Modifikationen erzielt mittels Phasenmodulation (räumlicher Lichtmodulator, SLM) oder Variation der Prozessparameter (Fokuslage, Intensität usw.)

Die Bearbeitung wird nachstehend mit Bezug auf die Figur anhand eines Verfahrensbeispiels einer Prozessabfolge zur Erzeugung von zwei unterschiedlichen Kegelwinkeln α, β innerhalb einer Durchbrechung mit einem Kegelwinkel α von ca. 15° im oberen Bereich und mit einem Kegelwinkel β, von ca. 2° im unteren Bereich näher erläutert.

Zunächst erfolgt eine Laserstrukturierung mit zwei Laserpulsen mit unterschiedlichen Pulsenergien, wodurch Modifikationen durch die gesamte Dicke des Glassubstrates 2 und zusätzlich einer Kette von Bläschen im oberen Teil des Glassubstrates 2 erzeugt werden.

Anschließend wird das Glassubstrat 2 mit flusssäurebeständiger Folie einseitig laminiert und in einem Halterahmen fixiert. Danach erfolgt das Ätzen der von der Folie nicht geschützten Seite in Flusssäure (1 bis 20 %ige HF) bei einer Temperatur zwischen 5 °C bis 30 °C für 5 bis 60 Minuten.

Hiernach wird ein Bereich der Folie, welche den Bereich der einzubringenden Ausnehmung schützt, entfernt, beispielsweise bei einer als UV-Release-Tape ausgeführten Folie mit UV-Licht bestrahlt oder bei einer als Heat-Release-Tape ausgeführten Folie mit Wärme behandelt. Die Folie verbleibt im Randbereich der einzubringenden Ausnehmung, wodurch die Handhabung des Glassubstrates 2 verbessert wird. Nach dem nachfolgenden erneuten Ätzprozess wird die Folie vollständig entfernt.

Anstelle der Folie kann beispielsweise auch eine Beschichtung mit Chrom durchgeführt werden, wobei das erste Ätzbad so eingestellt wird, dass die Beschichtung erst in einem nachfolgenden Ätzbad abgetragen wird.

Weiterhin kann auch eine weitere Lasermodifikation, beispielsweise nach einer vorausgegangenen Ätzbehandlung und eine einseitige oder beidseitige Ätzbehandlung vorgenommen werden.

Sehr dünne Glassubstrate 2 mit einer Stärke von weniger als 100 µm werden zur besseren Handhabung während der Prozessierung bevorzugt in Waferrahmen befestigt, beispielsweise auf diesen aufgeklebt.

Sehr dünne Glassubstrate 2 mit einer Stärke von weniger als 100 µm werden zur besseren Handhabung während der Prozessierung bevorzugt in Waferrahmen befestigt, beispielsweise auf diesen aufgeklebt.

## Patentansprüche

1. Verfahren zum Einbringen zumindest einer Ausnehmung, insbesondere Durchbrechung (1), in ein transparentes oder transmissives Material eines Glassubstrats (2), wobei mittels elektromagnetischer Strahlung das Material entlang einer Strahlachse (s) selektiv modifiziert wird und die Ausnehmungen anschließend durch einen oder mehrere Ätzschritte erzeugt werden, wobei in einem modifizierten und in den nicht modifizierten Bereichen unterschiedliche Ätzraten auftreten, **dadurch gekennzeichnet, dass** entlang der Strahlachse (s) in dem Material durch die elektromagnetische Strahlung Modifikationen mit unterschiedlichen Charakteristika innerhalb der modifizierten Bereiche erzeugt werden, sodass der Ätzprozess in dem Material inhomogen verläuft und die Ätzraten in den mit unterschiedlichen Charakteristika modifizierten Bereichen bei unveränderten Ätzbedingungen voneinander abweichen, sodass Ausnehmungen mit unterschiedlichen Öffnungswinkeln (α, β) und/oder Durchmessern auf beiden Seiten des Glassubstrats (2) erzeugt werden, wobei die unterschiedlichen Charakteristika der Modifikationen durch Veränderung der Strahlform der elektromagnetischen Strahlung, insbesondere mittels Phasenmodulation, und/oder durch Variation der Pulsenergie, der Strahlform und/oder der Intensität erzielt werden.

2. Verfahren nach Anspruch 1, **dadurch gekennzeichnet, dass** die unterschiedlichen Charakteristika der Modifikationen durch Variation der Fokuslage erzielt werden.

3. Verfahren nach Anspruch 1 oder 2 , **dadurch gekennzeichnet, dass** mehrfach ein Zyklus aus Modifikation und Ätzbehandlung des Materials durchlaufen wird.

4. Verfahren nach einem der vorhergehenden Ansprüche, **dadurch gekennzeichnet, dass** mehrere Ätzschritte, insbesondere mit unterschiedlichen Ätzbedingungen, durchgeführt werden.

5. Verfahren nach einem der vorhergehenden Ansprüche, **dadurch gekennzeichnet, dass** eine Oberfläche des insbesondere plattenförmigen Materials mit einem Ätzresist zumindest abschnittsweise abgedeckt wird und dadurch bei dem nachfolgenden Ätzverfahren vor dem Ätzangriff geschützt ist.

6. Verfahren nach einem der vorhergehenden Ansprüche, **dadurch gekennzeichnet, dass** durch die Wahl der Prozessparameter der Öffnungswinkel (α, β), insbesondere kleiner als 5° und/oder der Durchmesser der Ausnehmung eingestellt werden.

7. Verfahren nach einem der vorhergehenden Ansprüche, **dadurch gekennzeichnet, dass** die Differenz der Öffnungswinkel (α, β) aufgrund der Modifikationen mit unterschiedlichen Charakteristika mehr als 10° beträgt

## Claims

1. Method for introducing at least one recess, in particular through-hole (1), into a transparent or transmissive material of a glass substrate (2), wherein the material is selectively modified along a beam axis (s) by means of electromagnetic radiation and the recesses are subsequently produced by one or more etching steps, different etching rates occurring in a modified region and in the unmodified regions, **characterized in that** modifications with different characteristics within the modified regions are produced along the beam axis (s) in the material by the electromagnetic radiation, so that the etching process in the material takes place inhomogeneously and, with unaltered etching conditions, the etching rates in the regions modified with different characteristics differ from one another, so that recesses with different opening angles (α, β) and/or diameters on either side of the glass substrate (2) are produced, wherein the different characteristics of the modifications are obtained by modifying the beam shape of the electromagnetic radiation, in particular by means of phase modulation, and/or by varying the pulse energy, the beam shape and/or the intensity.

2. Method according to Claim 1, **characterized in that** the different characteristics of the modifications are achieved by variation of the focal position.

3. Method according to Claim 1 or 2, **characterized in that** a cycle of modification and etching treatment of the material is carried out several times.

4. Method according to one of the preceding claims, **characterized in that** a plurality of etching steps are carried out, in particular with different etching conditions.

5. Method according to one of the preceding claims, **characterized in that** a surface of the material, which is particularly in the shape of a plate, is covered at least in sections with an etching resist and is thereby protected against the etching attack during the subsequent etching method.

6. Method according to one of the preceding claims, **characterized in that** the aperture angles (α, β), in particular less than 5°, and/or the diameter of the recess are adjusted by the selection of the process parameters.

7. Method according to one of the preceding claims, **characterized in that** the difference of the aperture angles (α, β) as a result of the modifications with different characteristics is more than 10°.

## Revendications

1. Procédé de réalisation d'au moins un évidement, notamment d'une ouverture (1), dans un matériau transparent ou transmissif d'un substrat en verre (2), le matériau étant modifié sélectivement le long d'un ou plusieurs axes de faisceau au moyen d'un rayonnement électromagnétique et les évidements étant ensuite réalisés par une ou plusieurs étapes de gravure, différentes vitesses de gravure étant appliquées dans les zones modifiées et dans les zones non modifiées, **caractérisé en ce que** des modifications ayant des caractéristiques différentes sont générées dans le matériau le long de l'axe ou des axes de faisceau par le rayonnement électromagnétique à l'intérieur des zones modifiées de sorte que le processus de gravure dans le matériau s'étend de manière inhomogène et les vitesses de gravure dans les zones modifiées avec des caractéristiques différentes s'écartent les unes des autres dans des conditions de gravure inchangées de sorte que des évidements avec différents angles d'ouverture (α, ß) et/ou différents diamètres sont réalisés des deux côtés du substrat en verre (2), les différentes caractéristiques des modifications étant obtenues par modification de la forme de faisceau du rayonnement électromagnétique, notamment par modulation de phase, et/ou par variation de l'énergie d'impulsion, de la forme de faisceau et/ou de l'intensité.

2. Procédé selon la revendication 1, **caractérisé en ce que** les différentes caractéristiques des modifications sont obtenues par variation de la position du foyer.

3. Procédé selon la revendication 1 ou 2, **caractérisé en ce qu'**un cycle de modification et de traitement de gravure du matériau est effectué plusieurs fois.

4. Procédé selon l'une des revendications précédentes, **caractérisé en ce que** plusieurs étapes de gravure, notamment dans des conditions de gravure différentes, sont réalisées.

5. Procédé selon l'une des revendications précédentes, **caractérisé en ce qu'**une surface du matériau notamment en forme de plaque est au moins partiellement recouverte d'un vernis de gravure et est ainsi protégée contre l'attaque de gravure pendant le procédé de gravure ultérieur.

6. Procédé selon l'une des revendications précédentes, **caractérisé en ce que** le choix des paramètres de processus permet de régler l'angle d'ouverture (α, ß), notamment inférieur à 5°, et/ou le diamètre de l'évidement.

7. Procédé selon l'une des revendications précédentes, **caractérisé en ce que** la différence des angles d'ouverture (u, ß) est supérieure à 10° en raison des modifications présentant des caractéristiques différentes.
